Europäisches Patentamt

European Patent Office

Office européen des brevets

(19)

(11) **EP 1 114 200 B1**

(12) **FASCICULE DE BREVET EUROPEEN**

(45) Date de publication et mention
de la délivrance du brevet:
**08.05.2002 Bulletin 2002/19**

(21) Numéro de dépôt: **99940277.9**

(22) Date de dépôt: **02.09.1999**

(51) Int Cl.$^7$: **C23C 14/04**

(86) Numéro de dépôt international:
**PCT/FR99/02092**

(87) Numéro de publication internationale:
**WO 00/14294 (16.03.2000 Gazette 2000/11)**

(54) **PROCEDE POUR LE DEPOT SOUS VIDE D'UN SUBSTRAT COURBE**

VERFAHREN ZUM VAKUUMBESCHICHTEN EINES GEWÖLBTEN SUBSTRATES

METHOD FOR VACUUM DEPOSIT ON A CURVED SUBSTRATE

(84) Etats contractants désignés:
**AT BE CH CY DE DK ES FI FR GB GR IE IT LI LU
MC NL PT SE**
Etats d'extension désignés:
**AL LT LV MK RO SI**

(30) Priorité: **04.09.1998 FR 9811100**

(43) Date de publication de la demande:
**11.07.2001 Bulletin 2001/28**

(73) Titulaire: **ESSILOR INTERNATIONAL
Compagnie Générale d'Optique
F-94220 Charenton le Pont (FR)**

(72) Inventeurs:
• **COMBLE, Pascal
F-94170 Le Perreux-sur-Marne (FR)**

• **KELLER, Gerhard
F-94100 Saint Maur (FR)**
• **MOUHOT, Frédéric
F-77340 Pontault-Combault (FR)**

(74) Mandataire: **CABINET BONNET-THIRION
BP 966,
12 Avenue de la Grande-Armée
75829 Paris Cedex 17 (FR)**

(56) Documents cités:
**DE-C- 3 816 578          FR-A- 1 380 432
US-A- 3 627 569**

• **PATENT ABSTRACTS OF JAPAN vol. 012, no.
107 (P-686), 7 avril 1988 (1988-04-07) & JP 62
239103 A (ALPS ELECTRIC CO LTD), 20 octobre
1987 (1987-10-20)**

**Description**

La présente invention concerne d'une manière générale le traitement sous vide d'un quelconque substrat du genre suivant lequel, conformément à une technique de pulvérisation cathodique communément appelée "sputtering", on provoque, globalement, dans une enceinte, le dépôt, sur ce substrat, d'une couche de matériau en provenance d'une source de matériau donnée, en soumettant par exemple cette source de matériau, qui sert alors de cathode, à un bombardement ionique approprié dont il résulte que des particules lui sont arrachées, et celles-ci viennent alors se déposer sur le substrat.

Elle vise plus particulièrement le cas où le substrat traité est un substrat courbé, voire même un substrat fortement courbé, comme cela est le cas, au moins, de certains verres de lunettes, et, en particulier, pour ceux de forte puissance.

Par substrat courbé, on entend, donc, ici, d'une manière plus générale, un substrat qui, à la manière d'un verre de lunettes, comporte, dans au moins un plan transversal, une courbure plus ou moins accentuée.

Ainsi qu'on le sait, il est usuel d'appliquer un traitement sous vide à certains verres de lunettes, pour leur conférer des propriétés particulières, et, par exemple, des propriétés antireflet.

L'un des problèmes à résoudre en la matière est d'assurer toute l'uniformité d'épaisseur souhaitable à la couche de matériau alors déposée.

Par épaisseur, on entend ici, et dans tout ce qui suit, l'épaisseur optique de la couche déposée, c'est-à-dire le produit de l'épaisseur physique de cette couche par l'indice de réfraction du matériau qui la constitue.

A défaut d'une bonne uniformité pour cette épaisseur, tout éventuel reflet résiduel risque de conduire à des irisations intempestives.

Or l'épaisseur de la couche de matériau déposée est inversement proportionnelle à la distance du verre de lunettes, ou, d'une manière plus générale, du substrat traité, par rapport à la source de matériau correspondante.

Lorsque, comme en l'espèce, le substrat est courbé, cette distance est plus grande à sa périphérie qu'en son centre, et l'épaisseur du dépôt obtenu est donc plus petite à cette périphérie qu'à ce centre.

Cette différence d'épaisseur peut devenir sensible lorsque, pour des raisons pratiques, le substrat courbé est disposé à faible distance de la source de matériau, la différence de distance de sa périphérie et de son centre par rapport à cette source de matériau devenant alors importante du fait même de sa courbure.

Dans la pratique, cette différence d'épaisseur peut couramment atteindre 20 % selon les substrats et l'enceinte mise en oeuvre.

La présente invention a d'une manière générale pour objet une disposition permettant de manière très simple de réduire cette différence d'épaisseur.

De manière plus précise, elle a tout d'abord pour objet un procédé pour le traitement sous vide d'un quelconque substrat courbé, du genre suivant lequel on provoque la pulvérisation cathodique d'un matériau en provenance d'un substrat courbé, on provoque le dépôt, sur ce substrat courbé, d'une couche dudit matériau, ce procédé étant d'une manière générale caractérisé en ce qu'on interpose, entre le substrat courbé et la source de matériau, à distance du substrat courbé, un cache fixe par rapport au substrat courbé, des résultats particulièrement favorables étant obtenus avec un cache dont la projection sur un plan suivant une direction perpendiculaire à ce plan a une surface inférieure à 10 %, voire à 5 %, de la surface de la projection du substrat courbé sur ce même plan ; elle a encore pour objet tout cache propre à la mise en oeuvre d'un tel procédé.

Certes, il est déjà connu de mettre en oeuvre, pour des raisons diverses, un cache lors du traitement sous vide d'un substrat courbé, tel que cela est par exemple le cas dans le brevet américain No 5 225 057.

Mais, dans ce brevet américain No 5 225 057, le substrat courbé traité est entraîné en rotation sur lui-même, en sorte que le cache n'est pas fixe par rapport à lui.

En outre, ce cache n'est mis en oeuvre que pour limiter l'angle d'ouverture du faisceau par lequel se fait le dépôt recherché, sans qu'il en soit prévu une quelconque incidence sur l'épaisseur même de la couche de matériau obtenue au terme de ce dépôt.

Certes, également, il est déjà connu, notamment par le brevet américain No 5 389 397, de mettre en oeuvre, lors du traitement sous vide d'un substrat, un cache fixe par rapport à ce substrat.

Mais, dans ce brevet américain No 5 389 397, les substrats traités sont plats.

Eu égard aux particularités de dépôt intervenant lorsque le substrat est un substrat courbé, il n'était pas possible de penser a priori qu'un cache fixe pouvait également convenir pour un tel substrat courbé.

En outre, dans ce brevet américain No 5 389 397, le cache mis en oeuvre est plein.

Or, de manière assez surprenante, il s'avère que, avec le cache suivant l'invention, des résultats significatifs sont obtenus lorsque ce cache comporte une partie annulaire.

Sans qu'il y ait une certitude à ce sujet, on peut penser, par exemple, que, aux pressions de travail mises en oeuvre, qui sont en général supérieures à 0,1 Pa, le libre parcours moyen des particules de dépôt en jeu étant de l'ordre de quelques millimètres, ces particules de dépôt sont l'objet de réflexions multiples avec les atomes du gaz plasmogène, que, du fait de ces réflexions multiples, ainsi que du fait de la configuration de l'enceinte mise en oeuvre, il se crée normalement un flux de particules plus important en direction du centre du substrat qu'en direction de sa périphérie, et que, avec l'interposition d'un cache suivant l'invention, et, plus particulièrement, d'un cache comportant une partie annulaire, entre la source de matériau et le substrat, ce flux de particules est probablement moins directionnel, ce flux étant alors au moins partiellement limité au centre du substrat, là où, en l'absence d'un tel cache, on observe usuellement un surplus de matériau déposé.

Quoi qu'il en soit, il est observé, et les essais le confirment, que, avec un cache présentant suivant l'invention une partie annulaire, la différence d'épaisseur relevée, pour le dépôt obtenu, entre la périphérie du substrat courbé traité et le centre de celui-ci, au lieu d'être de l'ordre de 20 %, peut, avantageusement, être abaissée, les autres conditions étant égales par ailleurs, à moins de 15 %, voire, même, à moins de 10 %.

Des résultats encore plus satisfaisants peuvent être observés lorsque, suivant un développement de l'invention, le cache mis en oeuvre comporte, à l'intérieur de sa partie annulaire, au moins un croisillon qui relie l'une à l'autre deux zones de cette partie annulaire, par exemple suivant un diamètre de celle-ci, avec, éventuellement, dans ce cas, suivant un développement complémentaire de l'invention, à l'extérieur de la partie annulaire, à chacune des extrémités d'un tel croisillon, un bras qui s'étend radialement par rapport à la partie annulaire, dans le prolongement de ce croisillon.

Dans un tel cas, la différence d'épaisseur observée entre la périphérie du substrat courbé traité et le centre de celui-ci peut, avantageusement, être baissée, les autres conditions étant égales par ailleurs, à moins de 5 %.

Dans tous les cas, les résultats obtenus avec un cache suivant l'invention sont d'autant plus surprenants que, dans la pratique, ce cache peut avantageusement avoir, par rapport au substrat courbé traité, une extension relativement réduite, ce qui, si désiré, permet de limiter l'encombrement de l'ensemble à celui du seul substrat courbé, et ce qui permet, corollairement, d'éviter d'éventuelles difficultés d'ombrage.

Les caractéristiques et avantages de l'invention ressortiront d'ailleurs de la description qui va suivre, à titre d'exemple, en référence aux dessins schématiques annexés sur lesquels :

la figure 1 est une vue en perspective d'un substrat courbé à traiter, représenté en place sur un support, avec le cache qui lui est associé suivant l'invention ;
la figure 2 est une vue en coupe axiale de l'ensemble, suivant la ligne II-II de la figure 1 ;
la figure 3 est, reprise de la figure 1, mais à échelle différente, une vue en perspective du cache suivant l'invention, représenté isolément ;
la figure 4 est, à échelle supérieure, une vue partielle en coupe axiale de ce cache, suivant la ligne IV-IV de la figure 4 ;
la figure 5 est une vue partielle en perspective analogue à celle de la figure 3, pour une variante de réalisation ;
la figure 6 est, elle aussi, une vue en perspective analogue à celle de la figure 3, pour une autre variante de réalisation ;
la figure 7 est, à échelle supérieure, une vue partielle en coupe axiale de cette autre variante de réalisation, suivant la ligne VII-VII de la figure 6 ;
les figures 8, 9 et 10 sont des vues en perspective qui, elles aussi, analogues à celle de la figure 3, se rapportent, chacune respectivement, à d'autres variantes de réalisation du cache suivant l'invention.

Ces figures illustrent, à titre d'exemple, l'application de l'invention au cas où le substrat courbé 10 à traiter est un verre de lunettes, ou, plus précisément, un palet, de contour circulaire, dans lequel est ensuite détouré un tel verre de lunettes.

Soit $D_1$ le diamètre de ce substrat courbé 10 le long de son contour.

Ce diamètre $D_1$ est le plus souvent compris entre 65 mm et 80 mm.

Dans la forme de mise en oeuvre représentée,-le substrat courbé 10 est, à titre d'exemple, concavo-convexe.

Lorsqu'un traitement sous vide doit lui être appliqué, un tel substrat courbé 10 est usuellement porté, par sa périphérie, par un support 11 approprié à son maintien.

Ce support 11 étant bien connu par lui-même, et ne relevant pas, en propre, de la présente invention, il ne sera pas décrit ici.

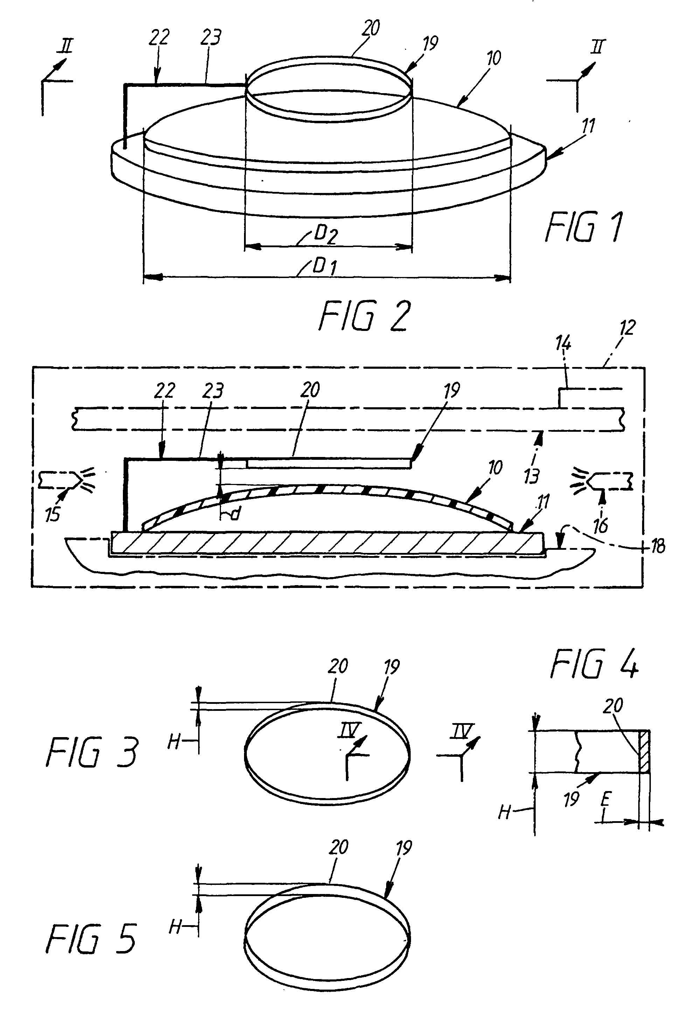

C'est en outre, par simple commodité, que, sur les figures 1 et 2, il se présente sous la forme d'un disque plat de contour circulaire.

En réalité, ce support 11 peut relever de configurations très diverses, voire, même, être ajouré.

Quoi qu'il en soit, pour le traitement sous vide recherché, et de manière connue en soi, on provoque le dépôt, sur le substrat courbé 10 ainsi porté par un support 11, dans une enceinte 12 schématisée en traits interrompus sur la figure 2, d'une couche de matériau en provenance d'une source de matériau 13 appropriée, elle-même schématisée en traits interrompus sur cette figure 2.

Une machine utilisée par exemple dans ce but est commercialisée par la Société APPLIED VISION Ltd, sous le nom commercial PLASMACOAT AR.10 (TM).

Cette machine est également décrite dans la demande de brevet internationale No WO-A-92 13114.

Par exemple, et tel que schématisé en 14 sur la figure 2, la source de matériau 13 est mise à un potentiel négatif, pour former une cathode, et on introduit, dans l'enceinte 12, d'une part, par exemple par une buse 15, un gaz inerte, par exemple de l'argon, et, d'autre part, par exemple par une buse 16, un gaz actif, par exemple de l'oxygène.

D'une manière générale, on met en oeuvre une pression de gaz supérieure à 0,1 Pa.

De préférence, cette pression de gaz est comprise entre 0,2 Pa et 2 Pa.

Corollairement, le support 11 est, le plus souvent, et tel que représenté, un support individuel, et, avec d'autres supports 11 de même type portant chacun un substrat courbé 10 à traiter, il est rapporté, tel que schématisé en traits interrompus sur la figure 2, sur un support collectif 18, par exemple en forme de plaque, monté rotatif dans l'enceinte 12.

En variante, le support 11 peut tout aussi bien défiler linéairement sous la source de matériau 13

Quoi qu'il en soit, le gaz inerte introduit par la buse 15 s'ionise à son entrée dans l'enceinte 12, en y formant en quelque sorte un plasma, et les ions positifs dont il est ainsi à l'origine viennent bombarder la source de matériau 13, qui forme cible, et ils arrachent ainsi à cette source de matériau 13 des particules qui, tout en se combinant avec le gaz actif introduit par la buse 16, viennent se déposer sur le substrat courbé 10, en formant à la surface de celui-ci la couche de matériau recherchée.

Les dispositions qui précèdent sont bien connues par elles-mêmes, et elles ne seront donc pas décrites plus en détail ici.

Suivant l'invention, on interpose, entre le substrat courbé 10 et la source de matériau 13, un cache 19 fixe par rapport au substrat courbé 10.

Préférentiellement, et tel que représenté, on choisit pour cache 19 un cache comportant une partie annulaire 20.

En pratique, cette partie annulaire 20 a un contour circulaire.

Par exemple, et tel que représenté, on choisit pour cache 19 un cache dont la partie annulaire 20 a, extérieurement, un diamètre $D_2$ inférieur à deux fois le diamètre $D_1$ du substrat courbé 10.

Plus précisément, on choisit préférentiellement pour cache 19 un cache dont la partie annulaire 20 a, extérieurement, un diamètre $D_2$ compris entre le quart du diamètre $D_1$ du substrat courbé 10 et deux fois ce diamètre $D_1$.

Il est possible, d'ailleurs, d'indiquer, à ce sujet, à titre d'exemple numérique, mais sans qu'il puisse en résulter une quelconque limitation de l'invention, que, avec un substrat courbé 10 dont le diamètre $D_1$ est de l'ordre de 65 mm, dont la puissance est de 6 dioptries, et dont le rayon de la face avant convexe est de 62,13 mm, des résultats satisfaisants ont été obtenus avec un cache 19 dont la partie annulaire 20 a, extérieurement, un diamètre $D_2$ compris entre 20 mm et 130 mm.

Quoi qu'il en soit, le substrat courbé 10 étant porté, comme indiqué ci-dessus, par un support 11, on fixe, par exemple, le cache 19 à ce support 11.

Dans la forme de réalisation représentée, le cache 19 est, en pratique, rapporté sur le support 11 par une potence 22, et il s'étend en porte à faux à compter de l'extrémité de la traverse 23 de cette potence 22.

Bien entendu, on fait préférentiellement en sorte que cette potence 22 soit aussi petite que possible, afin de minimiser l'ombrage dont elle peut être à l'origine lors du dépôt de matériau sur le substrat courbé 10.

Quoi qu'il en soit, et tel que représenté, on dispose préférentiellement le cache 19 à distance du substrat courbé 10, sensiblement parallèlement à celui-ci.

Soit d cette distance, mesurée entre le cache 19, au bas de celui-ci, et le point le plus haut du substrat courbé 10, comme relevé sur la figure 2.

Par exemple, cette distance d est inférieure à deux fois le diamètre $D_1$ du substrat courbé 10.

Préférentiellement, elle est comprise entre le dixième du diamètre $D_1$ du substrat courbé 10 et la moitié de ce diamètre $D_1$.

Il est possible, d'ailleurs, d'indiquer à ce sujet, à titre d'exemple non limitatif, et dans les mêmes conditions que ci-dessus, que des résultats satisfaisants ont été obtenus avec une distance d entre le cache 19 et le substrat courbé 10 inférieure à 130 mm et préférentiellement comprise entre 7 mm et 30 mm.

Dans les formes de réalisation représentées sur les figures 1 à 5, le cache 19 se réduit à sa partie annulaire 20.

Par exemple, et tel que représenté, la section transversale de cette partie annulaire 20 est globalement rectangulaire.

Soit H sa hauteur, mesurée suivant l'axe du substrat courbé 10, et, donc, perpendiculairement au support 11 portant celui-ci, et soit E son épaisseur radiale, mesurée parallèlement à ce support 11.

Préférentiellement, et cela est le cas dans les formes de réalisation représentées, la partie annulaire 20 du cache 19 a, en section transversale, une hauteur H supérieure à son épaisseur radiale E.

Par exemple, cette hauteur H est inférieure à 15 mm.

Préférentiellement, elle est comprise entre 1 mm et 15 mm.

Il est possible, d'ailleurs, d'indiquer, à ce sujet, à titre d'exemple non limitatif, et dans les mêmes conditions que ci-dessus, que des résultats satisfaisants ont été obtenus avec une hauteur H comprise entre 1 mm et 10 mm.

De même, des résultats satisfaisants ont été obtenus avec une épaisseur radiale E inférieure à 2 mm.

Par exemple, cette épaisseur radiale E est inférieure à 1 mm.

Il est possible, d'ailleurs, d'indiquer à ce sujet, à titre d'exemple non limitatif, et dans les mêmes conditions que ci-dessus, que des résultats satisfaisants ont été obtenus avec une épaisseur radiale E de l'ordre de 0,1 mm.

Il apparaît, par ailleurs, que, pour l'obtention de résultats satisfaisants, il est souhaitable de tenir compte du diamètre $D_1$ du substrat courbé 10 à traiter dans le choix du diamètre $D_2$ de la partie annulaire 20 du cache 19 mis en oeuvre.

Suivant l'invention, on fait en sorte de respecter, pour ce faire, l'une au moins des formules suivantes, et, préférentiellement, chacune de celles-ci :

$$d + H = A.\frac{D_2}{2} \qquad (I)$$

$$d = B.\frac{D_2}{2} \qquad (II)$$

$$D_1 = C.D_2 \qquad (III)$$

dans lesquelles, d, H, $D_1$ et $D_2$ sont les paramètres déjà précisés ci-dessus, et dans lesquels :

A est un coefficient compris entre 0,8 et 1, en étant par exemple de l'ordre de 0,92
B est un coefficient compris entre 0,7 et 0,9, en étant par exemple de l'ordre de 0,77
et C est un coefficient compris entre 2 et 3, en étant par exemple de l'ordre de 2,5.

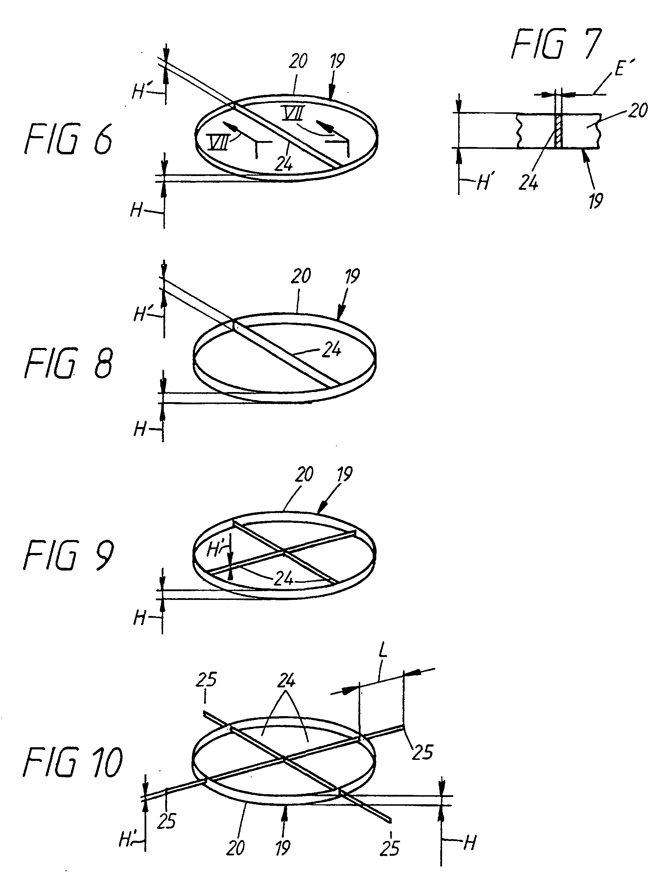

Dans la forme de réalisation représentée sur la figure 5, la hauteur H a une valeur double de la valeur qui est la sienne dans la forme de réalisation représentée sur la figure 3.

Dans les formes de réalisation représentées sur les figures 6 à 10, le cache 19 comporte, à l'intérieur de sa partie annulaire 20, au moins un croisillon 24 qui relie l'une à l'autre deux zones de cette partie annulaire 20.

Par exemple, et tel que représenté sur les figures 6 à 8, un seul croisillon 24 est prévu, et ce croisillon 24 s'étend suivant un diamètre de la partie annulaire 20.

En outre, dans ces formes de réalisation, la section transversale de ce croisillon 24 est globalement rectangulaire, et elle s'étend sensiblement parallèlement à celle de la partie annulaire 20.

Dans les formes de réalisation représentées sur les figures 6 à 8, le croisillon 24 a, lui-même, en section transversale, une hauteur H' égale à la hauteur H de la partie annulaire 20, et une épaisseur radiale E' égale à l'épaisseur radiale E de cette partie annulaire 20.

Il s'étend donc à niveau avec la partie annulaire 20, tant du côté d'une des tranches de celle-ci que du côté de l'autre de ces tranches.

Mais, bien entendu, le croisillon 24 peut, en variante, avoir, en section transversale une hauteur H' différente de la hauteur H de la partie annulaire 20, et/ou une épaisseur radiale E' différente de l'épaisseur radiale E de cette partie annulaire 20.

Cela est le cas, à titre d'exemple, au moins pour la hauteur H', dans les formes de réalisation représentées sur les figures 9 et 10, dans lesquelles, par ailleurs, le cache 19 suivant l'invention comporte au moins deux croisillons 24.

Par exemple, et tel que représenté, seuls deux croisillons 24 sont ainsi prévus, et ils sont perpendiculaires l'un à l'autre, en s'étendant en pratique chacun suivant un diamètre de la partie annulaire 20.

Par exemple, ces deux croisillons 24 ont chacun une constitution analogue à celle du croisillon 24 précédent.

Mais, dans les formes de réalisation représentées, leur hauteur H' est égale à la moitié de la hauteur H de la partie annulaire 20.

Par exemple, et tel que représenté, ils s'étendent à mi-hauteur sur cette partie annulaire 20.

Dans la forme de réalisation représentée sur la figure 10, enfin, le cache 19 comporte, à l'extérieur de sa partie annulaire 20, au moins un bras 25, qui s'étend radialement par rapport à cette partie annulaire 20, en porte à faux à compter de celle-ci.

En pratique, ce bras 25 a une structure analogue à celle des croisillons 24, et il s'étend dans le prolongement d'un tel croisillon 24.

En pratique, également, il y a un bras 25 à chacune des extrémités d'un croisillon 24, et, pour l'un et l'autre des croisillons 24, les divers bras 25 ainsi mis en oeuvre ont une même longueur.

Il est possible d'indiquer, à ce sujet, à titre d'exemple non limitatif, et dans les mêmes conditions que ci-dessus, que des résultats satisfaisants ont été obtenus avec des bras 25 ayant une longueur L égale à 10 mm.

A la figure 6, la hauteur H de la partie annulaire 20 du cache 19 est égale à celle de la forme de réalisation de la figure 3.

Par contre, sur les figures 8 à 10, cette hauteur H a une valeur égale à celle de la forme de réalisation représentée sur la figure 5.

Mais, dans l'un et l'autre cas, cette hauteur H peut être différente.

En outre, suivant une variante de réalisation non représentée, cette hauteur H de la partie annulaire 20 du cache 19 varie suivant le pourtour de celui-ci, en s'étendant, par exemple, entre 2 mm et 15 mm, pour tenir compte du mouvement relatif intervenant entre ce cache 19 et la source de matériau 13.

Dans tous les cas, du fait même de la structure du cache 19 suivant l'invention, l'ombre portée de celui-ci sur le substrat courbé 10 traité est avantageusement particulièrement faible.

Plus précisément, on choisit, à cet égard, suivant l'invention, pour cache 19, un cache dont la projection sur un plan suivant une direction perpendiculairement à ce plan a une surface inférieure à 10 % de la surface de la projection du substrat courbé 10 sur ce même plan dans les mêmes conditions, le plan de projection ainsi pris en compte étant par exemple celui du support 11 sur lequel repose le substrat courbé 10 traité.

Plus précisément, encore, on choisit, préférentiellement, pour cache 19 suivant l'invention, un cache dont la projection, dans les conditions indiquées ci-dessus, a une surface inférieure à 5 % de la surface de la projection du substrat courbé 10.

Dans tous les cas, également, et pour autant qu'on puisse l'affirmer, le matériau constitutif du cache 19 suivant l'invention semble sans incidence sur les résultats obtenus.

Ce matériau peut donc être divers.

Par exemple, il peut s'agir aussi bien de papier que d'acier inoxydable.

Le tableau ci-après résume, figure par figure, les résultats obtenus avec les diverses formes de réalisation succinctement décrites ci-dessus.

Dans ce tableau, $\Delta$ donne, en pour-cent, la différence d'épaisseur observée pour le dépôt obtenu au cours d'un traitement donné entre la périphérie du substrat courbé 10 et le centre de celui-ci.

|  | $D_1$ mm | $D_2$ mm | H mm | E mm | $\Delta$ % |
|---|---|---|---|---|---|
| Figures 3, 4 | 65 | 26 | 1 | 0,1 | 14 |
| Figure 5 | 65 | 26 | 2 | 0,1 | 12 |
| Figures 6, 7 | 65 | 26 | 1 | 0,1 | 13 |
| Figure 8 | 65 | 26 | 2 | 0,1 | 7 |
| Figure 9 | 65 | 26 | 2 | 0,1 | 3,7 |
| Figure 10 | 65 | 26 | 2 | 0,1 | 3,4 |

Bien entendu, la présente invention ne se limite pas aux formes de réalisation décrites et représentées, mais englobe toute variante d'exécution et/ou de mise en oeuvre.

En particulier, le contour de la partie annulaire du cache mis en oeuvre n'est pas nécessairement circulaire.

Par exemple, ce contour pourrait être elliptique.

Il pourrait même avoir une forme plus complexe, en étant par exemple en spirale.

En outre, il est possible d'intervenir sur la pression des gaz à l'intérieur de l'enceinte mise en oeuvre.

Par exemple, en élevant cette pression, il est possible d'inverser la différence d'épaisseur observée, l'épaisseur du dépôt obtenu étant alors plus faible au centre du substrat courbé traité qu'à la périphérie de celui-ci.

**Revendications**

1. Procédé pour le traitement sous vide d'un quelconque substrat courbé, du genre suivant lequel on provoque la pulvérisation cathodique d'un matériau en provenance d'une source de matériau donnée, on provoque le dépôt, sur ce substrat courbé (10), d'une couche dudit matériau donnée, **caractérisé en ce qu'**on interpose, entre le substrat courbé (10) et la source de matériau (13), à distance du substrat courbé (10), un cache (19) fixe par rapport au substrat courbé (10), et dont la projection sur un plan suivant une direction perpendiculaire à ce plan a une surface inférieure à 10 % de la surface de la projection du substrat courbé (10) sur ce même plan.

2. Procédé suivant la revendication 1, **caractérisé en ce qu'**on choisit pour cache (19) un cache dont la projection a une surface inférieure à 5 % de la surface de la projection du substrat courbé (10).

3. Procédé suivant la revendication 1 ou 2, **caractérisé en ce qu'**on choisit pour cache (19) un cache comportant une partie annulaire (20).

4. Procédé suivant la revendication 3, **caractérisé en ce que**, le substrat courbé (10) ayant lui-même un contour circulaire, on choisit pour cache (19) un cache dont la partie annulaire (20) a un diamètre ($D_2$) inférieur à deux fois le diamètre ($D_1$) du substrat courbé (10).

5. Procédé suivant la revendication 4, **caractérisé en ce qu'**on choisit pour cache (19) un cache dont la partie annulaire (20) a un diamètre ($D_2$) compris entre le quart du diamètre ($D_1$) du substrat courbé (10) et deux fois ce diamètre ($D_1$).

6. Procédé suivant l'une quelconque des revendications 1 à 5, **caractérisé en ce qu'**on dispose le cache (19) à une distance (d) du substrat courbé (10), sensiblement parallèlement à celui-ci.

7. Procédé suivant la revendication 6, **caractérisé en ce qu'**on dispose le cache (19) à une distance (d) du substrat courbé (10) inférieure à deux fois le diamètre ($D_1$) de celui-ci.

8. Procédé suivant la revendication 7, **caractérisé en ce qu'**on dispose le cache (19) à une distance (d) du substrat courbé (10) comprise entre le dixième du diamètre ($D_1$) de celui-ci et la moitié de ce diamètre ($D_1$).

9. Procédé suivant l'une quelconque des revendications 1 à 8, **caractérisé en ce que**, le substrat courbé (10) étant porté par un support (11), on fixe le cache (19) à ce support (11).

10. Procédé suivant l'une quelconque des revendications 1 à 9, **caractérisé en ce qu'**on met en oeuvre une pression de gaz supérieure à 0,1 Pa.

11. Procédé suivant l'une quelconque des revendications 1 à 10, **caractérisé en ce qu'**on fait en sorte de respecter l'une au moins des formules suivantes :

$$d + H = A.\frac{D_2}{2} \tag{I}$$

$$d = B.\frac{D_2}{2} \tag{II}$$

$$D_1 = C.D_2 \tag{III}$$

dans lesquelles :

d est la distance entre le cache (19) et le point le plus haut du substrat courbé (10) traité
H est la hauteur de la partie annulaire (20) du cache (19)
$D_1$ est le diamètre du substrat courbé (10)

D$_2$ est le diamètre de la partie annulaire (20) du cache (19)
A est un coefficient compris entre 0,8 et 1, en étant par exemple de l'ordre de 0,92
B est un coefficient compris entre 0,7 et 0,9, en étant par exemple de l'ordre de 0,77
et C est un coefficient compris entre 2 et 3, en étant par exemple de l'ordre de 2,5.

12. Cache pour le traitement sous vide d'un substrat courbé, **caractérisé en ce que**, pour la mise en oeuvre d'un procédé conforme à l'une quelconque des revendications 3, 4, il comporte une partie annulaire (20).

13. Cache suivant la revendication 12, **caractérisé en ce que** sa partie annulaire (20) a, en section transversale, une hauteur (H) supérieure à son épaisseur radiale (E).

14. Cache suivant la revendication 13, **caractérisé en ce que** la hauteur (H) de la partie annulaire (20) du cache (19) est inférieure à 15 mm.

15. Cache suivant l'une quelconque des revendications 13, 14, **caractérisé en ce que** la hauteur (H) de la partie annulaire (20) du cache (19) varie suivant son pourtour, en s'étendant, par exemple, entre 2 mm et 15 mm.

16. Cache suivant l'une quelconque des revendications 12 à 15, **caractérisé en ce que** la section transversale de sa partie annulaire (20) est globalement rectangulaire.

17. Cache suivant l'une quelconque des revendications 12 à 16, **caractérisé en ce qu'**il se réduit à sa partie annulaire (20).

18. Cache suivant l'une quelconque des revendications 12 à 16, **caractérisé en ce qu'**il comporte, à l'intérieur de sa partie annulaire (20), au moins un croisillon (24) qui relie l'une à l'autre deux zones de cette partie annulaire (20).

19. Cache suivant la revendication 18, **caractérisé en ce que** le croisillon (24) s'étend suivant un diamètre de la partie annulaire (20).

20. Cache suivant les revendications 16 et 18, prises conjointement, **caractérisé en ce que** la section transversale du croisillon (24) est globalement rectangulaire, et elle s'étend sensiblement parallèlement à celle de la partie annulaire (20).

21. Cache suivant l'une quelconque des revendications 18 à 20, **caractérisé en ce qu'**il comporte au moins deux croisillons (24).

22. Cache suivant la revendication 21, **caractérisé en ce que** les deux croisillons (24) sont perpendiculaires l'un à l'autre.

23. Cache suivant l'une quelconque des revendications 12 à 22, **caractérisé en ce qu'**il comporte, à l'extérieur de sa partie annulaire (20), au moins un bras (25), qui s'étend radialement par rapport à cette partie annulaire (20), en porte à faux à compter de celle-ci.

24. Cache suivant les revendications 18 et 23, prises conjointement, **caractérisé en ce que** le bras (25) s'étend dans le prolongement d'un croisillon (24).

25. Cache suivant la revendication 24, **caractérisé en ce que** le bras (25) a une structure analogue à celle du croisillon (24).

26. Cache suivant l'une quelconque des revendications 24, 25, **caractérisé en ce qu'**il y a un bras (25) à chacune des extrémités d'un croisillon (24).

**Claims**

1. Process for the vacuum treatment of any curved substrate, of the kind in which a material coming from a given source of material is sputtered and a layer of said given material is deposited on this curved substrate (10), **characterized in that** a mask (19) is interposed between the curved substrate (10) and the source of material (13) at a certain distance from the curved substrate (10), the said mask being stationary with respect to the curved substrate (10), and whose projection on a plane in a direction perpendicular to this plane has an area of less than 10% of the area of the projection of the curved substrate (10) on this same plane.

2.  Process according to claim 1, **characterized in that** a mask whose projection has an area of less than 5% of the area of the projection of the curved substrate (10) is chosen for the mask (19).

3.  Process according to claim 1 or 2, **characterized in that** a mask having an annular part (20) is chosen for the mask (19).

4.  Process according to claim 3, **characterized in that**, since the curved substrate (10) itself has a circular contour, a mask whose annular part (20) has a diameter ($D_2$) of less than twice the diameter ($D_1$) of the curved substrate (10) is chosen for the mask (19).

5.  Process according to claim 4, **characterized in that** a mask whose annular part (20) has a diameter ($D_2$) of between one quarter of the diameter ($D_1$) of the curved substrate (10) and twice this diameter ($D_1$) is chosen for the mask (19).

6.  Process according to any one of claims 1 to 5, **characterized in that** the mask (19) is placed at a distance (d) from the curved substrate (10), approximately parallel to the latter.

7.  Process according to claim 6, **characterized in that** the mask (19) is placed at a distance (d) from the curved substrate (10) of less than twice the diameter ($D_1$) of the latter.

8.  Process according to claim 7, **characterized in that** the mask (19) is placed at a distance (d) from the curved substrate (10) of between one tenth of the diameter ($D_1$) of the latter and half this diameter ($D_1$).

9.  Process according to any one of claims 1 to 8, **characterized in that**, since the curved substrate (10) is supported by a support (11), the mask (19) is fastened to this support (11).

10. Process according to any one of claims 1 to 9, **characterized in that** a gas pressure of greater than 0.1 Pa is used.

11. Process according to any one of claims 1 to 10, **characterized in that** care is taken to ensure that at least one of the following formulae is satisfied:

$$d + H = A \cdot \frac{D_2}{2} \qquad \text{(I)}$$

$$d = B \cdot \frac{D_2}{2} \qquad \text{(II)}$$

$$D_1 = C \cdot D_2 \qquad \text{(III)}$$

in which:

d is the distance between the mask (19) and the highest point of the treated curved substrate (10);
H is the height of the annular part (20) of the mask (19);
$D_1$ is the diameter of the curved substrate (10);
$D_2$ is the diameter of the annular part (20) of the mask (19);
A is a coefficient of between 0.8 and 1, being for example about 0.92;
B is a coefficient of between 0.7 and 0.9, being for example about 0.77;
and C is a coefficient of between 2 and 3, being for example about 2.5.

12. Mask for the vacuum treatment of a curved substrate, **characterized in that**, for the implementation of a process according to either of claims 3, 4, it has an annular part (20).

**13.** Mask according to claim 12, **characterized in that** its annular part (20) has, in cross section, a height (H) greater than its radial thickness (E).

**14.** Mask according to claim 13, **characterized in that** the height (H) of the annular part (20) of the mask (19) is less than 15 mm.

**15.** Mask according to either of claims 13, 14, **characterized in that** the height (H) of the annular part (20) of the mask (19) varies along its perimeter, extending, for example, between 2 mm and 15 mm.

**16.** Mask according to any one of claims 12 to 15, **characterized in that** the cross section of its annular part (20) is generally rectangular.

**17.** Mask according to any one of claims 12 to 16, **characterized in that** it is reduced to its annular part (20).

**18.** Mask according to any one of claims 12 to 16, **characterized in that** it includes, inside its annular part (20), at least one crosspiece (24) which links together two regions of this annular part (20).

**19.** Mask according to claim 18, **characterized in that** the crosspiece (24) extends along a diameter of the annular part (20).

**20.** Mask according to claims 16 and 18, taken together, **characterized in that** the cross section of the crosspiece (24) is generally rectangular, and it extends approximately parallel to that of the annular part (20).

**21.** Mask according to any one of claims 18 to 20, **characterized in that** it includes at least two crosspieces (24).

**22.** Mask according to claim 21, **characterized in that** the two crosspieces (24) are perpendicular to each other.

**23.** Mask according to any one of claims 12 to 22, **characterized in that** it includes, on the outside of its annular part (20), at least one arm (25) which extends radially with respect to this annular part (20), in a cantilever fashion from the latter.

**24.** Mask according to claims 18 and 23, taken together, **characterized in that** the arm (25) extends along the extension of a crosspiece (24).

**25.** Mask according to claim 24, **characterized in that** the arm (25) has a structure similar to that of the crosspiece (24).

**26.** Mask according to either of claims 24, 25, **characterized in that** there is an arm (25) at each of the ends of a crosspiece (24).

**Patentansprüche**

**1.** Verfahren zur Vakuumbehandlung eines beliebigen gekrümmten oder gewölbten Substrates, bei welchem die kathodische Pulverisation eines Materials, ausgehend von einer gegebenen Materialquelle veranlasst wird, und bei welchem die Fällung an dem gewölbten Substrat (10) einer Schicht des genannten gegebenen Materials veranlasst wird, **dadurch gekennzeichnet, dass** zwischen dem gewölbten Substrat (10), und der Materialquelle (13) unter Abstand von dem gewölbten Substrat (10), ein, mit Bezug auf das gewölbte Substrat (10) feststehender Cache bzw. eine mit Bezug auf das gewölbte Substrat (10) feststehende Blende (19) zwischengelagert wird, wobei die lotrechte Projektion davon in einer Ebene eine Fläche von weniger als 10% der Fläche der Projektion des gewölbten Substrates (10) in dieser Ebene einnimmt.

**2.** Verfahren nach Anspruch 1, **dadurch gekennzeichnet, dass** für den Cache oder die Blende (19) ein Cache oder eine Blende verwendet wird, dessen bzw. deren Projektion eine Fläche von weniger als 5% der Fläche oder Oberfläche der Projektion des gewölbten Substrates (10) annimmt.

**3.** Verfahren nach Anspruch 1 oder 2, **dadurch gekennzeichnet, dass** als Cache oder Blende (19) ein Cache oder eine Blende gewählt wird, der bzw. die einen ringförmigen Abschnitt (20) umfasst.

4. Verfahren nach Anspruch 3, **dadurch gekennzeichnet, dass** das gewölbte Substrat (10) selbst über einen kreisförmigen Umriss verfügt, wobei als Cache oder Blende (19) ein Cache oder eine Blende gewählt wird, deren bzw. dessen ringförmiger Teil (20) über einen Durchmesser ($D_2$) verfügt, der kleiner ist als der zweifache Durchmesser ($D_1$) des gewölbten oder gekrümmten Substrates (10).

5. Verfahren nach Anspruch 4, **dadurch gekennzeichnet, dass** man als Blende oder Cache (19) eine Blende oder einen Cache verwendet, deren bzw. dessen ringförmiger Abschnitt bzw. Teil (20) einen Durchmesser ($D_2$) aufweist, enthalten zwischen einem Viertel des Durchmessers ($D_1$) des gewölbten Substrates (10) und dem Zweifachen dieses Durchmessers ($D_1$).

6. Verfahren nach einem der Ansprüche 1 bis 5, **dadurch gekennzeichnet, dass** der Cache oder die Blende (19) bei einem Abstand (d) bezüglich des gewölbten Substrates (10) und im wesentlichen parallel diesbezüglich angeordnet wird.

7. Verfahren nach Anspruch 6, **dadurch gekennzeichnet, dass** der Cache oder die Blende (19) bei einem Abstand (d) des gewölbten Substrates (10) angeordnet wird, welcher kleiner ist als zweimal der Durchmesser ($D_1$) davon.

8. Verfahren nach Anspruch 7, **dadurch gekennzeichnet, dass** der Cache (19) bei einem Abstand oder einer Entfernung (d) des gewölbten Substrates (10) angeordnet wird, enthalten zwischen einem Zehntel des Durchmessers ($D_1$) und der Hälfte dieses Durchmessers ($D_1$).

9. Verfahren nach einem der Ansprüche 1 bis 8, **dadurch gekennzeichnet, dass** das gewölbte Substrat (10) von einer Stütze (11) getragen wird, wobei der Cache oder die Blende (19) an dieser Stütze (11) befestigt wird.

10. Verfahren nach einem der Ansprüche 1 bis 9, **dadurch gekennzeichnet, dass** ein Gasdruck von mehr als 0,1 Pa verwendet wird.

11. Verfahren nach einem der Ansprüche 1 bis 10, **dadurch gekennzeichnet, dass** zumindest eine der folgenden Gleichungen eingehalten wird:

$$d + H = A \times \frac{D_2}{2}$$

$$d = B \times \frac{D_2}{2}$$

$$D_1 = C \times D_2$$

wobei gilt:

d ist der Abstand oder die Entfernung zwischen dem Cache bzw. der Blende (19) und dem höchsten Punkt des behandelten Substrates (10)
H ist die Höhe des ringförmigen Abschnitts oder Teils (20) der Blende bzw. des Caches (19)
$D_1$ ist der Durchmesser des gewölbten Substrats (10)
$D_2$ ist der Durchmesser des ringförmigen Abschnitts (20) des Caches (19)
A ist ein Koeffizient, enthalten zwischen 0,8 und 1 und beträgt beispielhaft etwa 0,92
B ist ein Koeffizient enthalten zwischen 0,7 und 0,9 und beträgt beispielhaft in etwa 0,77 und
C ist ein Koeffizient enthalten zwischen 2 und 3 und beträgt beispielhaft etwa 2,5.

12. Cache oder Blende zur Vakuumbehandlung eines gewölbten Substrates, **dadurch gekennzeichnet, dass** zum Einsatz in einem Verfahren nach einem der Ansprüche 3, 4 dieser einen ringförmigen Teil oder Abschnitt (20) umfasst.

**13.** Cache nach Anspruch 12, **dadurch gekennzeichnet, dass** der ringförmige Teil oder Abschnitt (20) im Querschnitt über eine Höhe (H) verfügt, die größer ist als die radiale Dicke (E) davon.

**14.** Cache nach Anspruch 13, **dadurch gekennzeichnet, dass** die Höhe (H) des ringförmigen Teils (20) des Cache (19) kleiner ist als 15 mm.

**15.** Cache nach einem der Ansprüche 13, 14, **dadurch gekennzeichnet, dass** die Höhe (H) des ringförmigen Teils (20) der Blende bzw. des Cache (19) sich umfangsmäßig verändert und z. B. vorliegt bei einem Wert von zwischen 2 mm und 15 mm.

**16.** Cache nach einem der Ansprüche 12 bis 15, **dadurch gekennzeichnet, dass** der Querschnitt des ringförmigen Abschnitts (20) global oder im wesentlichen rechteckförmig ist.

**17.** Cache nach einem der Ansprüche 12 bis 16, **dadurch gekennzeichnet, dass** er bei dem ringförmigen Abschnitt (20) reduziert oder verjüngt vorliegt.

**18.** Cache nach einem der Ansprüche 12 bis 16, **dadurch gekennzeichnet, dass** er im Inneren seines ringförmigen Abschnitts (20) zumindest eine Kreuzstrebe (24) umfasst, die die eine mit der anderen Zone des ringförmigen Abschnitts (20) verbindet.

**19.** Cache nach Anspruch 18, **dadurch gekennzeichnet, dass** sich die Kreuzstrebe (24) entlang einem Durchmesser des ringförmigen Abschnitts (20) erstreckt.

**20.** Cache nach den Ansprüchen 16 und 19, gemeinsam, **dadurch gekennzeichnet, dass** der Querschnitt der Kreuzstrebe (24) global oder im wesentlichen rechteckförmig ist, wobei sich dieser im wesentlichen parallel zu jenem des ringförmigen Abschnitts (20) erstreckt.

**21.** Cache nach einem der Ansprüche 18 bis 20, **dadurch gekennzeichnet, dass** zumindest zwei Kreuzstreben (24) vorgesehen sind.

**22.** Cache nach Anspruch 21, **dadurch gekennzeichnet, dass** die zwei Kreuzstreben (24) senkrecht mit Bezug zueinander verlaufen.

**23.** Cache nach einem der Ansprüche 12 bis 22, **dadurch gekennzeichnet, dass** äußerlich des ringförmigen Abschnittes (20) zumindest ein Arm (25) vorgesehen ist, der sich radial mit Bezug auf den ringförmigen Abschnitt (20) erstreckt und zwar diesbezüglich fluchtend.

**24.** Cache nach den Ansprüchen 18 und 23, gemeinsam, **dadurch gekennzeichnet, dass** sich der Arm (25) in der Verlängerung einer Kreuzstrebe (24) erstreckt.

**25.** Cache nach Anspruch 24, **dadurch gekennzeichnet, dass** der Arm (25) über eine Struktur analog zu jener der Kreuzstrebe verfügt.

**26.** Cache nach einem der Ansprüche 24, 25, **dadurch gekennzeichnet, dass** ein Arm (25) an jedem der Enden einer Kreuzstrebe (24) vorgesehen ist.

FIG 1

FIG 2

FIG 4

FIG 3

FIG 5

FIG 6

FIG 7

FIG 8

FIG 9

FIG 10